# EUROPÄISCHE PATENTSCHRIFT

(11) **EP 1 676 299 B1**
(45) Veröffentlichungstag und Bekanntmachung des Hinweises auf die Patenterteilung: **01.07.2009**
(21) Anmeldenummer: 04802641.3
(22) Anmeldetag: 25.10.2004
(51) Int. Cl.: H01L 21/20

(54) **KRISTALLZÜCHTUNGSANLAGE**
CRYSTAL GROWING UNIT
INSTALLATION DE CRISTALLOGENESE

(30) Priorität: 23.10.2003 DE 10349339
(43) Veröffentlichungstag der Anmeldung: 05.07.2006
(73) Patentinhaber: Crystal Growing Systems GmbH, 35614 Asslar (DE)
(72) Erfinder: MÜHE, Andreas, D-35576 Wetzlar. (DE); ALTEKRÜGER, Burkhard, 63755 Alzenau (DE); VONHOFF, Axel, 77948 Friesenheim-Oberweier (DE)
(74) Vertreter: Hebing, Norbert
(86) Internationale Anmeldenummer: PCT/DE2004/002373
(87) Internationale Veröffentlichungsnummer: WO 2005/041278

(56) Entgegenhaltungen:
- EP-A- 0 628 645
- DE-A1- 2 107 646
- US-A- 5 196 085
- US-A1- 2002 092 461
- PATENT ABSTRACTS OF JAPAN Bd. 010, Nr. 139 (C-348), 22. Mai 1986 (1986-05-22) & JP 60 264391 A (NIPPON DENKI KK), 27. Dezember 1985 (1985-12-27)
- PATENT ABSTRACTS OF JAPAN Bd. 010, Nr. 071 (C-334), 20. März 1986 (1986-03-20) & JP 60 210592 A (EMU SETETSUKU KK), 23. Oktober 1985 (1985-10-23)
- PATENT ABSTRACTS OF JAPAN Bd. 018, Nr. 344 (C-1218), 29. Juni 1994 (1994-06-29) & JP 06 081086 A (HITACHI METALS LTD), 22. März 1994 (1994-03-22)
- PATENT ABSTRACTS OF JAPAN Bd. 015, Nr. 357 (C-0866), 10. September 1991 (1991-09-10) & JP 03 141187 A (SHIN ETSU CHEM CO LTD), 17. Juni 1991 (1991-06-17)
- PATENT ABSTRACTS OF JAPAN Bd. 013, Nr. 372 (C-627), 17. August 1989 (1989-08-17) & JP 01 126293 A (TOSHIBA CERAMICS CO LTD), 18. Mai 1989 (1989-05-18)

## Beschreibung

Die Erfindung bezieht sich auf eine Kristallzüchtungsanlage, insbesondere Halbleiter-Kristallzüchtungsanlage, mit einem beheizbaren Tiegel für eine Schmelze und einer koaxial zum Tiegel angeordneten Spulenanordnung zur Erzeugung eines Magnetfeldes in der Schmelze, wobei die Spulenanordnung drei oder mehr Spulen umfasst, die in axialer Richtung übereinander angeordnet sind und die jeweils mit einer Wechselspannung beaufschlagt sind, wobei die an einer Spule angelegte Wechselspannung gegenüber der an der Nachbarspule angelegten Wechselspannung phasenverschoben ist.

Bei der Züchtung von Halbleiterkristallen aus einer Schmelze spielt die Schmelzströmung und der damit verbundene konvektive Wärmetransport eine wesentliche Rolle für die sich ergebenden Temperaturverteilungen, die Form der Phasengrenze, die damit verbundenen thermischen Spannungen im wachsenden Kristall und damit letztendlich für die erreichbare Kristallqualität. Außerdem spielen die Temperaturfluktuationen an der Phasengrenze, die durch die Konvektion hervorgerufen werden können, eine entscheidende Rolle für die im Produktionsprozess erzielbare einkristalline Ausbeute. So führt, z. B. bei der Züchtung von Silizium-Einkristallen nach dem Czochralski-Verfahren (CZ), insbesondere bei zunehmenden Schmelzeinwaagen die thermische Auftriebskonvektion zu einer turbulenten Schmelzströmung, die mit ausgeprägten Temperaturfluktuationen verbunden ist. Zur Lösung dieser Problematik wurden bisher sowohl der Einsatz statischer Magnetfelder, die die Schmelzströmung nach dem Prinzip der Wirbelstrombremse dämpfen, als auch der Einsatz zeitabhängiger Magnetfelder, die eine kontrollierte, erzwungene Konvektion verursachen und der turbulenten Auftriebskonvektion entgegenwirken, vorgeschlagen und technisch verwirklicht.

Der Einsatz zeitabhängiger Magnetfelder bietet neben der Möglichkeit zur Unterdrückung freier, turbulenter Konvektion den Vorteil, dass auch in Schmelzen mit nicht vorhandener oder nur schwach ausgeprägter freier Konvektion gezielt Schmelzströmungen angetrieben werden können. So führt z. B. die stabile thermische Schichtung bei der Züchtung von Verbindungshalbleiterkristallen nach dem Vertical-Gradient-Freeze-Verfahren (VGF-Verfahren) dazu, dass thermische Auftriebskonvektion praktisch nicht auftritt und der Wärmetransport in der Schmelze rein diffusiv ist. In diesem Fall kann eine durch zeitabhängige Magnetfelder erzwungene Konvektion der Schmelze den effektiven Wärmetransport erhöhen und die Temperaturverteilung in der Züchtungsanordnung und letztlich die Form der Phasengrenze günstig beeinflussen.

US 2002/0092461 offenbart eine Kristallzüchtungsanlage mit einem Spulensystem zur Erzeugung eines magnetischen Wanderfeldes und mit einem gesonderten Heizer.

DE 2107646 offenbart eine Kristallzüchtungsanlage mit einer Widerstandsheizvorrichtung zur Erzeugung von Wärme und von einem rotierenden magnetischen Feld.

Die bisherigen Systeme konnten aber nicht in allen Punkten überzeugen. Insbesondere war die Anordnung von Widerstandsheizelementen des Widerstandsheizers zum Erhitzen der Schmelze und die Anordnung von Spulen zur Erzeugung des Magnetfeldes sehr platzraubend. Außerdem ist Folgendes zu beachten: Grundsätzlich unterscheiden sich die Anlagen, die nach dem Vertical Gradient Freeze-Verfahren (VGF) arbeiten von denen, die nach dem Czochralski-Verfahren (CZ) arbeiten, in ihrem Aufbau. So wird beim VGF-Verfahren unter hohem Überdruck gearbeitet, so dass der Kessel aus Stahl gefertigt sein muss, um dem hohen Druck standzuhalten. Der Stahlkessel aber würde ein durch eine außerhalb des Kessels angeordnete Spule erzeugtes Magnetfeld wenigstens weitgehend abschirmen, so dass im Inneren des Schmelztiegels, der aus Bornitrid oder Quarzglas gefertigt ist, kein genügend starkes magnetisches Wanderfeld entstehen würde, um die Schmelze zu durchmischen. D.h. die Spule müsste im Inneren des Kessels möglichst nahe am Tiegel, aber außerhalb des Tiegels angeordnet werden.

Da aber im Inneren des Kessels auch die Tiegelheizung vorgesehen ist und die Spule gekühlt wird, würde die Spule die Heizleistung des Heizers wenigstens teilweise wegkühlen. Im Inneren des Tiegels kann die Spule nicht angeordnet werden, da sie hier chemische Reaktionen mit der Schmelze hervorrufen oder wegen der hohen Temperatur der Schmelze selber schmelzen oder - wenn gekühlt - das Schmelzen des Siliziums verhindern würde.

Die Erfindung beruht daher auf dem Problem, mit einfachen Mitteln eine Magnetfeldkonfiguration zu schaffen, die geeignet ist, Konvektionen innerhalb der Schmelze in einem Maße zu steuern, dass der aus der Schmelze gezogene Kristall möglichst homogen wird und dabei die Schmelze erwärmt.

Zur Lösung des Problems sieht die Erfindung eine Kristallzüchtungsvorrichtung nach dem Oberbegriff des Anspruches 1 vor, bei der die Spulen von einem hohlzylindrischen Körper aus einem elektrisch leitenden Material gebildet sind, wobei dieser durch eine mehrfach umlaufenden Schlitz einen einlagigen, spiralförmig umlaufenden Strompfad bildet, der durch an die Spannungsversorgung anschließbare Kontaktpunkte in Abschnitte unterteilt ist, die jeweils eine Spule bilden.

Der Erfindungsgedanke besteht somit darin, eine hochtemperaturfeste Spule zu verwenden, die nicht gekühlt werden muss. Der nächste Erfindungsschritt ist, den sowieso benötigten Heizer mit der gewünschten Spule zu kombinieren, indem die Spule aus massiven Graphitleiterstäben geformt wird, die bei angepasstem Widerstand das richtige Magnetfeld erzeugt und die gewünschte Heizleistung abgibt.

Beim Czochralski-Verfahren wird ein Tiegel z.B. aus Quarzglas in einem Vakuumkessel bei Unterdruck und Schutzgas betrieben. Bekannt sind hier Heizer aus Graphit, die um den Tiegel herum gebaut sind. Die Stromschienen sind hierbei mäanderförmig in einer Weise angeordnet, die entsteht, wenn man einen vollen Graphitzylinder abwechselnd von oben nach unten und von unten nach oben einschlitzt und jeweils einen Steg für die Querverbindung stehen lässt. Hierbei kompensieren sich aber die aufwärts und abwärts laufenden Ströme hinsichtlich ihrer magnetfelderzeugenden Wirkung, so dass kein signifikantes Magnetfeld im Tiegel entsteht.

Der Erfindungsgedanke beim CZ-Verfahren ist nun, den schon bekannten Graphitheizer so umzugestalten, dass die Stromschienen spiralförmig um den Tiegel herumgeführt werden, so dass die Stromrichtung immer gleich ist. Die erfindungsgemäße Spulenanordnung für das CZ-Verfahren wirkt auf die Schmelze wie ein Linearmotor, wobei die Bewegungsrichtung der äußeren Zonen der Schmelze je nach Stromrichtung aufwärts oder abwärts gerichtet ist. Hierbei kann der Skin-Effekt ausgenutzt werden, so dass mit steigender Frequenz des Drehstromes eine immer dünnere Zone in der Schmelze bewegt wird.

Mit der Spulenanordnung lässt sich ein magnetisches Wanderfeld erzeugen, das in den Bereich der Halbleiterschmelze eindringt und dadurch bestimmte, für den Kristallzüchtungsprozess günstige Strömungen der elektrisch leitfähigen Schmelze hervorruft. Insbesondere lässt sich durch die Änderung der Frequenz der Wechselspannung, so wie durch die Änderung der Phasenverschiebung, die wiederum durch die Anzahl der Spulen bestimmt ist, eine bestimmte Geschwindigkeit einstellen, mit der sich das Magnetfeld in axialer Richtung durch die Schmelze bewegt. Die Schmelze muss außerdem auf einer Temperatur gehalten werden, die in der Regel ein wenig über dem Schmelzpunkt des jeweiligen zu schmelzenden Materials liegt. Dazu werden Widerstandsheizer um den Tiegel herum angeordnet. Die Spulen können zusätzlich die Heizfunktion übernehmen: Der durch die Spulen fließende Strom erzeugt aufgrund deren elektrischer Widerstände Wärme, die sowohl zum Schmelzen des Materials im Tiegel als auch zur Aufrechterhaltung der Schmelztemperatur dient.

Die erfindungsgemäße Lösung hat insbesondere den Vorteil, dass der hohlzylindrische Körper wegen seiner weitgehend bis auf dünne Schlitze geschlossenen Innenfläche eine besonders gute, weil gleichmäßig strahlende Wärmestrahlungsquelle bildet.

Vorzugsweise werden die Spulen elektrisch leitend in Form einer Stern- oder Dreieckschaltung miteinander verbunden, wobei die Spulen entsprechend ihrer Schaltungsanordnung an die Pole einer Drehstromquelle angeschlossen sind. Derartige Drehstromquellen stehen in der Regel an den Aufstellungsplätzen für Kristallzüchtungsvorrichtungen zur Verfügung, so dass ohne zusätzlichen Aufwand eine erfindungsgemäße Stromversorgung für die Spulen gegeben ist.

Um die Heizleistung unabhängig von der zeitlichen Änderung des Magnetfeldes, die allein die Stärke der induzierten Ströme bestimmt, einstellen zu können, werden die Spulen zusätzlich an eine Gleichspannungsquelle angeschlossen, die zusätzlich zum Wechselstrom einen Gleichstrom in den Spulen erzeugt, der allein für die Heizleistung verantwortlich ist.

Besonders einfach lässt sich der hohlzylindrische Körper mit einem spiralförmigen Schlitz versehen, wenn dieser im stets gleichen Richtungssinn den hohlzylindrischen Körper durchläuft.

Damit die Spulen mit Strom versorgt werden können, besitzen die zur Bildung von drei Spulen in axialer Richtung übereinander angeordneten Abschnitte je zwei Kontaktpunkte für den Anschluss an die Phasen einer Drehstromquelle.

Die Kontaktpunkte sind mit an der Innen- oder Außenmantelfläche des hohlzylindrischen Körpers verlaufenden elektrisch leitenden Schienen verbunden, die an einer Stirnseite des hohlzylindrischen Körpers in Anschlüssen enden, die mit den Phasen einer Drehstromquelle verbunden sind. Dies hat den Vorteil, dass die Anschlüsse am Gehäuseboden der Kristallzüchtungsvorrichtung angeordnet sind und damit ein die Spule, bzw. den Widerstandsheizer umgebender Isolationsmantel keine Durchbrüche für die Anschlüsse aufzuweisen braucht. Dies ergibt eine sehr kompakte und sehr gut isolierte Anlage.

Auch die Schienen können ebenfalls als Widerstandsheizelement eines Widerstandsheizers fungieren und werden dazu an eine Gleichspannungsquelle angeschlossen.

Unter Berücksichtigung aller zuvor genannten Bauelemente entsteht eine Vorrichtung zur elektrischen Widerstandsbeheizung einer Halbleiter-Kristallzüchtungsanlage bei gleichzeitiger Erzeugung eines magnetischen Wanderfeldes. Insbesondere sieht die Erfindung somit eine Anordnung elektrischer Widerstandsheizelemente in einer Anlage zur Züchtung einkristalliner Halbleiterkristalle aus der Schmelze vor, die so gestaltet sind, dass der zur Beheizung in den Widerstandsheizelementen fließende Wechselstrom zugleich ein magnetisches Wanderfeld erzeugt. Die Erfindung besteht somit im Wesentlichen aus einer Vorrichtung zur elektrischen Widerstandsbeheizung einer Halbleiter-Kristallzüchtungsanlage, die dadurch bestimmt ist, dass der im Wesentlichen hohlzylindrisch ausgebildete Widerstandsheizer aus drei in axialer Richtung übereinander angeordneten Abschnitten besteht, bei denen jeweils durch einen im Wesentlichen spiralförmigen Schlitz der Strompfad einer einlagigen Spule definiert ist und die den gleichen Umlaufsinn des spiralförmigen Schlitzes haben, und dass die drei Abschnitte über je zwei Kontaktpunkte für den Anschluss an die drei Phasen einer Drehstromquelle verfügen.

Die Doppelnutzung der Spulen als Widerstandsheizer und als Magnetfelderzeuger hat weiterhin den Vorteil, dass diese wie die bisherigen Widerstandsheizer, die ausschließlich der Beheizung der Schmelze dienen, unmittelbar am Tiegel innerhalb eine Kessels angeordnet werden können. Dies steht im Gegensatz zu den bisher bekannten Anordnungen, bei denen die Feldspulen zur Magnetfelderzeugung getrennt vom Widerstandsheizer außerhalb des Kessels angeordnet sind.

Bei solchen Anlagen, z. B. zur Silizium-Kristallzüchtung nach dem Czochralski-Verfahren, sind deshalb Kessel aus Quarzglas zum Einsatz gekommen, die die zeitabhängigen Magnetfelder, welche durch Spulenanordnungen außerhalb des Kessels erzeugt werden, nicht wesentlich abschirmen. Allerdings sind diese Quarzglaskessel extrem teuer und nicht in den Durchmessern herstellbar, die bei den größten in der Entwicklung befindlichen Kristallziehanlagen relevant sind. Im Fall der Anlagen für die Züchtung von Verbindungshalbleiterkristallen nach dem VGF-Verfahren kommt somit das Problem hinzu, dass eine Kesselwand aus Quarzglas für die in der industriellen Produktion übliche Züchtung unter Hochdruckbedingungen nicht in Frage kommt. Andererseits ist die Verwendung einer gebräuchlichen Spulenanordnung, z. B. aus Kupferdraht, innerhalb des wassergekühlten Anlagenkessels aus thermischen Gründen nicht praktikabel.

Die Erfindung löst das Problem somit durch die Verwendung eines elektrischen Widerstandsheizers, der die Schmelze in Form eines hohlzylindrischen Körpers umgibt, der über eine Anordnung von Schlitzen verfügt, welche den Heizstrom auf eine im Wesentlichen spiralförmige Bahn zwingt, so dass der Widerstandsheizer zugleich als einlagige Spule zur Erzeugung eines Magnetfeldes wirkt. Als Material für den Widerstandsheizer kann besonders vorteilhaft Graphit eingesetzt werden, wodurch in einer Schutzgasatmosphäre eine Temperaturbeständigkeit bis über 2000°C erreicht wird. Die Verwendung zylindrischer Widerstandsheizelemente aus isostatisch gepresstem Graphit ist in der Halbleiter-Kristallzüchtungsindustrie heute technischer Standard. Bei einem Betrieb des Widerstandsheizers mit Wechselstrom entsteht ein zeitabhängiges Wechselfeld.

Die hier vorgestellte Erfindung erzielt somit den Vorteil, dass der zur elektrischen Beheizung der Anlage benötigte Strom gleichzeitig zur Erzeugung eines magnetischen Wanderfeldes benutzt wird. Dadurch sind weder separate Feldspulen, noch eine separate Stromversorgung für die Feldspulen erforderlich. Weiterhin ist der Widerstandsheizer, der zugleich als Spulenanordnung ausgebildet ist, hochtemperaturbeständig und umgibt unmittelbar die heiße Kernzone der Anlage und damit den Schmelzbereich. Dadurch wird das Volumen, innerhalb dessen das Magnetfeld erzeugt werden muss, minimiert. Weiterhin muss das magnetische Wechselfeld nicht die Kesselwand der Kristallzüchtungsanlage durchdringen, wodurch die Kesselwand in konventioneller Weise als Stahlkessel ausgeführt werden kann. Dadurch treten außerdem keine Abschirmungsprobleme für den Bereich außerhalb der Anlage auf. Im Fall einer Hochdruck-Kristallzüchtungsanlage wird die Erzeugung von magnetischen Wanderfeldern im Bereich der Schmelze durch die Erfindung überhaupt erst möglich. Ein weiterer wesentlicher Vorteil der hier vorgestellten Erfindung besteht darin, dass die hohlzylindrische Geometrie der Heizer-Spulen-Anordnung der bereits heute am weitesten verbreiteten Heizeranordnung von Kristallzüchtungsanlagen entspricht und damit ohne großen konstruktiven Aufwand mit bestehenden Anlagen kombiniert oder sogar nachgerüstet werden kann, sofern eine ausreichende Anzahl von Stromdurchführungen zur Verfügung steht.

Im Folgenden soll anhand eines Ausführungsbeispieles die Erfindung näher erläutert werden. Dazu zeigen:
- Fig.1: ein hohlzylindrisches Widerstandsheizelement, das in drei Abschnitten durch einen umlaufenden spiralförmigen Schlitz jeweils eine magnetfelderzeugende Spule bildet,
- Fig.2: eine Dreieckschaltung für die Spulen nach Fig. 1,
- Fig.3: die Anordnung eines Widerstandsheizelementes gemäß der Erfindung in einer VGF- Kristallzüchtungsanlage und
- Fig.4: die Anordnung eines Widerstandsheizelementes gemäß der Erfindung in einer Kristallzüchtungsanlage nach dem CZ-Verfahren.

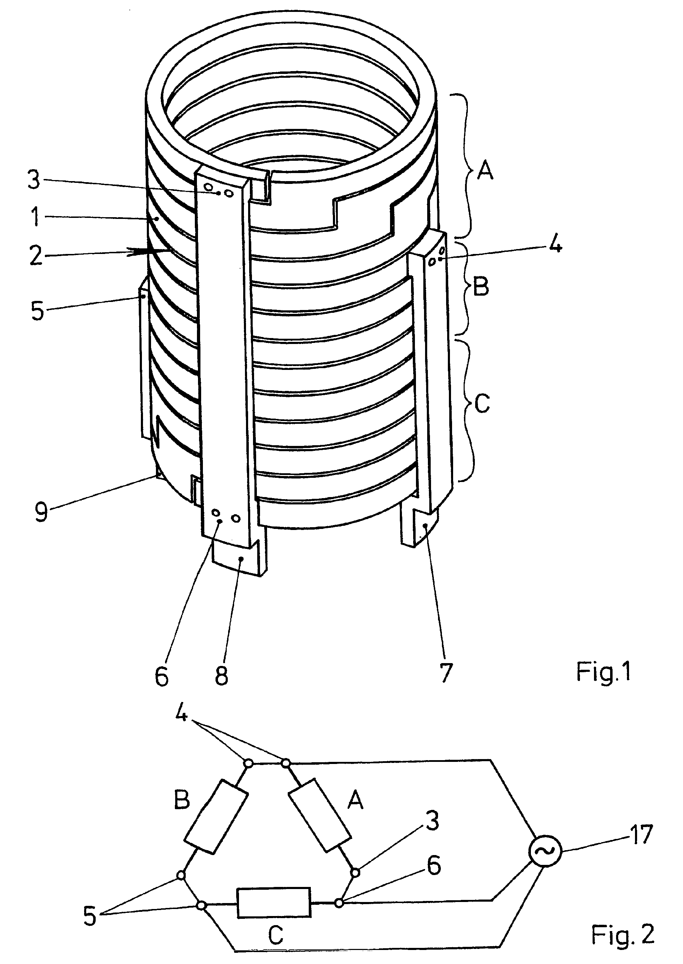

In Fig. 1 ist ein Beispiel für eine erfindungsgemäße Heizer-Spulen-Anordnung gezeigt, bei der ein hohlzylindrischer Körper 1, der besonders vorteilhaft aus isostatisch gepresstem Graphit hergestellt werden kann, mit einem im Wesentlichen spiralförmig verlaufenden Schlitz 2 versehen ist. Der Begriff "spiralförmig" schließt aber auch einen stufigen Verlauf ein, wie er in der Fig. 1 gezeigt ist. Außerdem verfügt die Anordnung über vier elektrische Kontaktpunkte 3, 4, 5 und 6, die der Einspeisung von Wechselströmen dienen. In dem in Fig. 1 gezeigten Beispiel wird eine Dreieckschaltung dadurch realisiert, dass die erste Phase einer Drehstromquelle mittels einer ersten sich über die Höhe des hohlzylindrischen Körpers 1 erstreckende Schiene 8 an die dadurch verbundenen ersten und vierten Kontaktpunkte 3, 6, die zweite Phase mittels einer zweiten Schiene 7 an den zweiten Kontaktpunkt 4 und die dritte Phase mittels einer dritten Schiene 9 an den dritten Kontaktpunkt 5 angeschlossen ist. Die Schienen 7, 8, 9 können mittels hochtemperaturbeständigen Schrauben, die z. B. aus dem Kohlefaserwerkstoff CFC gefertigt werden können, mit dem hohlzylindrischen Körper 1 verschraubt werden. Zum Anschluss an eine Drehstromquelle können die Schienen 7, 8, 9 mit drei Stromdurchführungen im Boden einer Kristallzüchtungsanlage verschraubt werden, an welche außerhalb der Anlage die entsprechenden Hochstromkabel angeklemmt werden.

Durch den Schlitz 2 bildet sich eine spiralförmig verlaufende, einen Strompfad formende Bahn, die durch die Kontaktpunkte 3 bis 6 in drei Abschnitte unterteilt ist, die jeweils eine Spule A, B, C bilden. Die Bahnen sind höher als breit und damit im Schnitt im Wesentlichen rechteckig.

Die Fig. 2 zeigt die Verschaltung der drei Spulen A, B, C zu einer Dreieckschaltung, wobei die jeweils aneinander grenzenden Enden der (zyklisch) benachbarten Spulen verbunden sind und an die Phasen einer Drehstromquelle angeschlossen sind.

Weiterhin besteht der in dieser Erfindung vorgestellte Widerstandsheizer aus drei in axialer Richtung übereinander angeordneten Abschnitten, die jeweils durch ein Paar von Abgriffen definiert sind und die damit drei übereinander angeordneten, koaxialen Spulen entsprechen. Die Abgriffe können durch Verbindung der Kontaktpunkte 3 und 6, 4 und 4, 5 und 5 - wie in Fig. 1 und Fig. 2 dargestellt - als Dreieckschaltung konfiguriert werden und an die drei Phasen einer Drehstromquelle angeschlossen werden. Alternativ können die drei Abschnitte an den Punkten 4 und 5 voneinander getrennt werden und dann als Sternschaltung konfiguriert werden und an die drei Phasen einer Drehstromquelle 17 angeschlossen werden. In beiden Fällen fließen in den drei Abschnitten drei um 120° phasenverschobene Wechselströme, die im Inneren der Anordnung ein magnetisches Wanderfeld erzeugen. Dieses Wanderfeld erzeugt im Randbereich einer innerhalb des Widerstandsheizers positionierten Halbleiterschmelze eine aufwärts oder abwärts gerichtete Strömung in Abhängigkeit von dem Umlaufsinn der Verbindung der drei Phasen mit den drei Abschnitten. Dadurch kann, z. B. im Fall einer Czochralski-Anordnung, der thermischen Auftriebskonvektion entgegengewirkt werden, während im Fall einer VGF-Anordnung durch eine Durchmischung der Schmelze der effektive Wärmetransport erhöht werden kann.

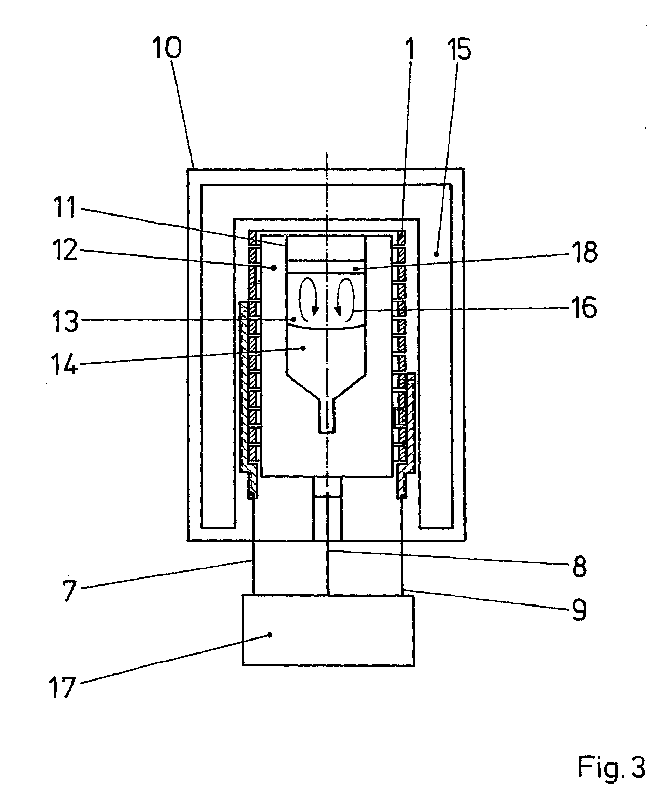

In Fig. 3 ist die Verwendung einer erfindungsgemäßen Heizer-Spulen-Anordnung, nämlich des hohlzylindrischen Körpers 1 wie oben beschrieben, in einer Hochdruck-Kristallzüchtungsanlage für die Züchtung von Verbindungshalbleiter-Kristallen nach dem VGF-Verfahren gezeigt, die aus einem wassergekühlten Hochdruckkessel 10 aus Stahl besteht, in dessen Innerem in einem Tiegel 11, welcher von einem Stütztiegel 12 gehalten wird, eine Schmelze, insbesondere eine Halbleiterschmelze 13, über dem wachsenden Einkristall 14 steht. Die zum Erschmelzen des Halbleitermaterials erforderlichen hohen Temperaturen werden durch den hohlzylindrischen Körper 1 in Kombination mit einem thermischen Isolationspaket 15 erreicht, das radial außen zum hohlzylindrischen Körper 1 angeordnet ist. In der Halbleiterschmelze 13 ist durch Pfeile ein typisches Strömungsmuster 16 dargestellt, das durch das von dem hohlzylindrischen Körper 1 in Verbindung mit einer Drehstromquelle 17 erzeugte magnetische Wanderfeld erzeugt wird.

Die Halbleiterschmelze 13 ist in einer VGF-Kristallzüchtungsanlage zur Züchtung von Verbindungshalbleiter-Kristallen typischerweise mit einer Boroxid-Abdeckschmelze 18 bedeckt, die in Kombination mit dem erhöhten Druck in der Anlage das Abdampfen der flüchtigen Komponenten des Verbindungshalbleitermaterials verhindert.

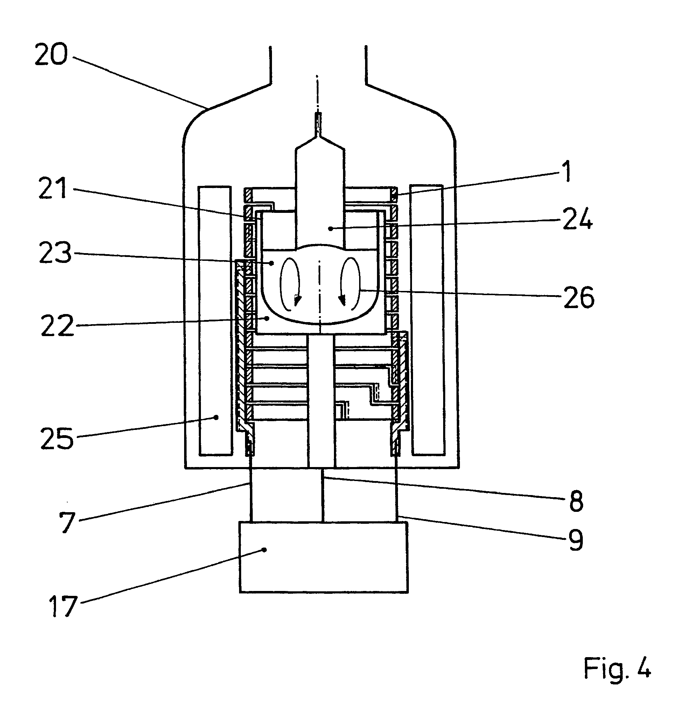

In Fig. 4 ist die Verwendung eines erfindungsgemäßen hohlzylindrischen Körpers 1 in einer Czochralski-Anlage zur Züchtung von Silizium- oder Germaniumkristallen gezeigt, die aus einem wassergekühlten Stahlkessel 20 besteht, in dessen Innerem in einem Tiegel 21, welcher von einem Stütztiegel 22 gehalten wird, eine Halbleiterschmelze 23 steht. Aus dieser Halbleiterschmelze 23 wird ein Einkristall 24 gezogen. Die zum Erschmelzen des Halbleitermaterials erforderlichen hohen Temperaturen werden durch den hohlzylindrischen Körper 1 in Kombination mit einem thermischen Isolationspaket 25 erreicht. In der Halbleiterschmelze 23 ist durch Pfeile ein typisches Strömungsmuster 26 dargestellt, das durch thermische Auftriebskonvektion entsteht und dem durch das von dem hohlzylindrischen Körper 1 in Verbindung mit einer Drehstromquelle 17 erzeugte magnetische Wanderfeld entgegengewirkt werden kann.

Die Erfindung kann grundsätzlich in allen Anlagen verwendet werden, in denen elektrisch leitfähige Schmelzen durch eine Widerstandsheizung bereitgestellt werden und in denen eine gezielte Beeinflussung der Schmelzströmung von technischer Bedeutung ist. Besonders vorteilhaft kann die Erfindung in all denjenigen Anlagen eingesetzt werden, in denen bereits heute zylindrische Widerstandsheizelemente in Schutzgasatmosphären unter Hochdruck oder vermindertem Druck oder im Vakuum eingesetzt werden.

### Bezugszeichenliste

- 1: hohlzylindrischer Körper
- 2: Schlitz
- 3: Kontaktpunkt
- 4: Kontaktpunkt
- 5: Kontaktpunkt

- 6: Kontaktpunkt
- 7: Schiene
- 8: Schiene
- 9: Schiene
- 10: Hochdruckkessel

- 11: Tiegel
- 12: Stütztiegel
- 13: Halbleiterschmelze
- 14: Einkristall
- 15: Isolationspaket

- 16: Strömungsmuster
- 17: Drehstromquelle
- 18: Boroxid-Abdeckschmelze

- 20: Stahlkessel

- 21: Tiegel
- 22: Stütztiegel
- 23: Halbleiterschmelze
- 24: Einkristall
- 25: Isolationspaket

- 26: Strömungsmuster

## Patentansprüche

1. Kristallzüchtungsanlage, insbesondere Halbleiter-Kristallzüchtungsanlage, mit einem beheizbaren Tiegel (11, 21) für eine Schmelze (13, 23) und einer koaxial zum Tiegel angeordneten Spulenanordnung zur Erzeugung eines Magnetfeldes in der Schmelze (13, 23), wobei die Spulenanordnung drei oder mehr Spulen umfasst, die in axialer Richtung übereinander angeordnet sind und die jeweils mit einer Wechselspannung beaufschlagt sind, wobei die an einer Spule angelegte Wechselspannung gegenüber der an der Nachbarspule angelegten Wechselspannung phasenverschoben ist, **dadurch gekennzeichnet, dass** die Spulen von einem hohlzylindrischen Körper (1) aus einem elektrisch leitenden Material gebildet sind, wobei dieser durch eine mehrfach umlaufenden Schlitz (2) einen einlagigen, spiralförmig umlaufenden Strompfad bildet, der durch an die Spannungsversorgung anschließbare Kontaktpunkte (3, 4, 5, 6) in Abschnitte unterteilt ist, die jeweils eine Spule bilden.

2. Kristallzüchtungsanlage nach Anspruch 1, **dadurch gekennzeichnet, dass** drei Spulen eine Einheit bilden und elektrisch in Form einer Stern- oder Dreieckschaltung miteinander verbunden sind, wobei die Spulen entsprechend ihrer Schaltungsanordnung an die Pole einer Drehstromquelle (17) angeschlossen sind.

3. Kristallzüchtungsanlage nach Anspruch 1 oder 2, **dadurch gekennzeichnet, dass** die Spulen zusätzlich an eine Gleichspannungsquelle angeschlossen sind.

4. Kristallzüchtungsanlage nach Anspruch 1, **dadurch gekennzeichnet, dass** der umlaufende Schlitz (2) im stets gleichen Richtungssinn den hohlzylindrischen Körper (1) durchläuft.

5. Kristallzüchtungsanlage nach Anspruch 2, **dadurch gekennzeichnet, dass** die zur Bildung von drei Spulen in axialer Richtung übereinander angeordneten Abschnitte über je zwei Kontaktpunkte (3, 4, 5, 6) für den Anschluss an die Phasen einer Drehstromquelle (17) verfügen.

6. Kristallzüchtungsanlage nach Anspruch 5, **dadurch gekennzeichnet, dass** die Kontaktpunkte (3, 4, 5, 6) mit an der Innen- oder Außenmantelfläche des hohlzylindrischen Körpers (1) verlaufenden elektrisch leitenden Schienen (7, 8, 9) verbunden sind, die an einer Stirnseite des hohlzylindrischen Körpers (1) in Anschlüssen enden, die mit den Phasen einer Drehstromquelle (17) verbunden sind.

7. Kristallzüchtungsanlage nach Anspruch 6, **dadurch gekennzeichnet, dass** die Schienen (7, 8, 9) als Widerstandsheizelemente genutzt werden und dazu an eine Gleichspannungsquelle angeschlossen sind.

8. Kristallzüchtungsanlage nach einem der vorhergehenden Ansprüche, **dadurch gekennzeichnet, dass** die einzelnen Spulen in einer Sternschaltung miteinander verbunden sind, wobei die Hauptschiene, die sich über die Höhe des hohlzylindrischen Körpers (1) erstreckt und Kontakt zu allen Spulen hat, an eine Gleichspannungsquelle angeschlossen ist.

9. Kristallzüchtungsanlage nach einem der vorhergehenden Ansprüche, **dadurch gekennzeichnet, dass** der hohlzylindrischen Körper (1) außerhalb des Tiegels (11, 21) aber innerhalb eines den Tiegel (11, 21) umgebenden Kessels (10, 20) angeordnet ist.

## Claims

1. A crystal growing system, in particular semiconductor crystal growing system, with a heatable crucible (11, 21) for a melt (13, 23) and a coil arrangement situated coaxially to the crucible to generate a magnetic field in the melt (13, 23), wherein the coil arrangement encompasses three or more coils situated one over the other in an axial direction and each exposed to an alternating voltage, wherein the alternating voltage applied to the one coil is phase-shifted relative to the alternating voltage applied to the adjacent coil, **characterized in that** the coils are formed by a hollow cylindrical body (1) made of an electrically conductive material, wherein the latter uses a repeatedly circulating slit (2) to form a single-ply, spirally circulating current path divided by the contact points (3, 4, 5, 6) connectable to the power supply into sections that each form a coil.

2. The crystal growing system according to claim 1, **characterized in that** three coils form a single unit, and are electrically interconnected in the form of a star or delta connection, wherein the coils are connected to the pole of a three-phase current source (17) based on their circuit arrangement.

3. The crystal growing system according to claim 1 or 2, **characterized in that** the coils additionally are connected to a direct voltage source.

4. The crystal growing system according to claim 1, **characterized in that** the circulating slit (2) always runs through the hollow cylindrical body (1) in the same direction.

5. The crystal growing system according to claim 2, **characterized in that** the sections arranged one over the other in an axial direction to form three coils each have two contact points (3, 4, 5, 6) for connection to the phases of a three-phase current source (17).

6. The crystal growing system according to claim 5, **characterized in that** the contact points (3, 4, 5, 6) are connected with electrically conductive rails (7, 8, 9) that run on the inner or outer jacket surface of the hollow cylindrical body (1) , and end in ports on one face of the hollow cylindrical body (1) that are connected with the phases of a three-phase current source (17).

7. The crystal growing system according to claim 6, **characterized in that** the rails (7, 8, 9) are used as resistance heating elements, to which end they are connected to a direct voltage source.

8. The crystal growing system according to one of the preceding claims, **characterized in that** the individual coils are interconnected in a delta circuit, wherein the main rail that extends over the height of the hollow cylindrical body (1) and contacts all coils is connected to a direct voltage source.

9. The crystal growing system according to one of the preceding claims, **characterized in that** the hollow cylindrical body 91) is arranged out side the crucible (11, 21) but inside a boiler (10, 20) that envelops the crucible (11, 21).

## Revendications

1. Installation de cristallogenèse, notamment installation de cristallogenèse à semi-conducteurs, comportant un creuset (11, 21) pouvant être chauffé prévu pour une masse en fusion (13; 23) et un dispositif à bobines disposé coaxialement au creuset afin de générer un champ magnétique dans la masse en fusion (13, 23), moyennant quoi le dispositif à bobines comprend trois ou plus bobines, qui sont disposées les unes sur les autres dans la direction axiale et qui sont respectivement sollicitées avec une tension alternative, moyennant quoi la tension alternative appliquée à une bobine est décalée en phase par rapport à la tension alternative appliquée à la bobine voisine, **caractérisée en ce que** les bobines sont formées d'un corps (1) cylindrique creux constitué d'un matériau électriquement conducteur, moyennant quoi celui-ci forme une voie de courant monocouche, faisant le tour en forme de spirale à travers une fente (2) faisant plusieurs tours, qui est divisée en portions par les points de contact (3, 4, 5, 6) pouvant être raccordés à l'alimentation en tension, lesquelles portions forment respectivement une bobine.

2. Installation de cristallogenèse selon la revendication 1, **caractérisée en ce que** trois bobines forment une unité et sont reliées électriquement les unes aux autres sous la forme d'un branchement en étoile ou triangulaire, moyennant quoi les bobines sont raccordées de manière correspondante à leur dispositif de branchement aux pôles d'une source de courant triphasé (17).

3. Installation de cristallogenèse selon la revendication 1 ou 2, **caractérisée en ce que** les bobines sont en outre raccordées à une source de tension continue.

4. Installation de cristallogenèse selon la revendication 1, **caractérisée en ce que** la fente (2) faisant le tour traverse le corps cylindrique creux (1) Constamment dans la même direction.

5. Installation de cristallogenèse selon la revendication 2, **caractérisée en ce que** afin de former trois bobines, des portions disposées les unes sur les autres dans la direction axiale disposent chacune de deux points de contact (3, 4, 5, 6) pour le raccordement aux phases d'une source de courant triphasé (17).

6. Installation de cristallogenèse selon la revendication 5, **caractérisée en ce que** les points de contact (3, 4, 5, 6) sont reliés aux rails (7, 8, 9) électriquement conducteurs s'étendant sur les surfaces de gaine intérieure et extérieure du corps cylindrique creux (1), qui aboutissent sur un côté frontal du corps cylindrique creux (1) aux raccords, qui sont reliés aux phases d'une source de courant triphasé (17).

7. Installation de cristallogenèse selon la revendication 6, **caractérisée en ce que** les rails (7, 8, 9) sont utilisés comme éléments chauffants à résistance et sont à cette fin raccordés à une source de tension continue.

8. Installation de cristallogenèse selon une des revendications précédentes, **caractérisée en ce que** les bobines individuelles sont reliées les unes aux autres dans un branchement en étoile, moyennant quoi le rail principal, qui s'étend sur la hauteur du corps cylindrique creux (1) et a un contact avec toutes les bobines, est raccordé à une source de tension continue.

9. Installation de cristallogenèse selon une des revendications précédentes, **caractérisée en ce que** le corps cylindrique creux (1) est disposé à l'extérieur du creuset (11, 21) mais à l'intérieur d'une cuve (10, 20) enveloppant le creuset (11, 21).
